# EUROPÄISCHE PATENTSCHRIFT

(11) **EP 2 317 236 B1**
(45) Veröffentlichungstag und Bekanntmachung des Hinweises auf die Patenterteilung: **10.06.2015**
(21) Anmeldenummer: 10189689.2
(22) Anmeldetag: 02.11.2010
(51) Int. Cl.: F24F 11/00, H05K 7/20

(54) **Klimatisierter Raum**
Air-conditioned area
Pièce climatisée

(30) Priorität: 02.11.2009 DE 202009013664 U
(43) Veröffentlichungstag der Anmeldung: 04.05.2011
(73) Patentinhaber: Weiss Klimatechnik GmbH, 35447 Reiskirchen-Lindenstruth (DE)
(72) Erfinder:
(74) Vertreter: Stoffregen, Hans-Herbert

(56) Entgegenhaltungen:
- EP-A2- 1 970 637
- DE-U1-202004 003 309
- DE-U1-202006 003 069
- JP-A- 2006 112 677
- US-A1- 2004 099 747
- US-A1- 2008 185 446

## Beschreibung

Die Erfindung bezieht sich auf einen klimatisierten Raum mit diesen begrenzende Wandungen, eine Kühleinrichtung sowie in dem Raum in Reihen angeordneten zu kühlenden elektrischen Geräten, wobei jede Reihe auf einer Seite einen Warmgang begrenzt, der zwischen zwei Reihen verläuft.

Aus der US-B-6,672,955 ist ein Rechenzentrum bekannt, in dem in Reihen angeordnete elektronische Geräte Warm- und Kaltgänge begrenzen. Die Kaltgänge sind eingehaust, um in diese über einen Zwischenboden gekühlte Luft zuzuführen. Die die elektrischen Geräte durchströmende Luft wird sodann im Deckenbereich abgesaugt, die anschließend einen Wärmetauscher durchsetzt, der von einem Kühlfluid durchströmt wird.

Um Rechner zu kühlen, werden diese nach der DE-U-20 2004 003 309 in einem doppelwandigen zylinderförmig geformten Rechnergehäuse angeordnet, das Lufteinlassöffnungen aufweist, durch die Kühlluft hindurchströmt, um die Rechner zu kühlen. Die erwärmte Luft wird sodann über einen Luftkanal abgeführt, in dem ein Ventilator angeordnet ist. Die Abluft kann wahlweise als Fortluft abgeführt werden oder im Kreislaufströmen, um nach Durchströmen einer Kühleinrichtung dem Raum erneut zugeführt zu werden, in dem sich das Rechnergehäuse befindet.

Nach der EP-B-1 488 305 wird in einem Schrank angeordneten wärmeerzeugenden Geräten gekühlte Luft zugeführt, die über einen in einem Klimagerät angeordneten Ventilator abgesaugt wird. Im Strömungsweg zum Ventilator ist in dem Klimagerät ein Wärmetauscher angeordnet.

Um einen Raum zu kühlen, in dem Rechner in Reihen angeordnet sind, sieht die DE-U-200 23 882 einen in dem Raum angeordneten Klimaschrank und einen in einem Hohlbodenraum angeordneten Ventilator vor, über den die Abluft durch den Klimaschrank gesaugt wird, um sodann die Zuluft über eine Bodenöffnung dem Raum wieder zuzuführen.

Aus der EP-A-1 970 637 ist ein Wandelement zur Temperierung eines Raumes bekannt. Hierzu ist das einen Wärmetauscher enthaltende Wandelement in einer Raumbegrenzungsfläche wie Wand integriert, so dass einige Bereiche des Wandelements auf der Raumbegrenzungsfläche aufliegen, andere Bereiche in der Raumbegrenzungsfläche eingebaut sind.

Gegenstand der WO-A-2006/124240 ist eine Kühlanordnung für Rechner, wobei in einem Zwischenraum ein Wärmetauscher angeordnet ist.

Nach der US-A-2004/0099747 ist in einem Rechnerraum ein gesondertes Klimagerät angeordnet.

Aus der DE-U-20 2009 002 033 ist eine Anordnung zum Klimatisieren eines Raums bekannt. An einer Wand ist ein Klimagerät angeordnet, dem Außenluft und/oder Abluft zuführbar ist.

Der vorliegenden Erfindung liegt die Aufgabe zu Grunde, eine Optimierung der Kühlung des Raums bei gleichzeitiger energetisch günstiger Betriebsweise zu ermöglichen. Auch soll eine problemlose Wartung der Kühleinrichtung möglich sein.

Erfindungsgemäß wird die Aufgabe im Wesentlichen dadurch gelöst, dass zumindest eine der den Raum begrenzenden Wandungen als Kühlerwand ausgebildet ist, über die dem Raum gekühlte Abluft zuführbar ist, die aus dem Warmgang abgesaugt ist, der gegenüber dem Raum strömungstechnisch getrennt ist.

Abweichend von vorbekannten Konstruktionen wird eine Wand eines Raums, in dem die zu kühlenden elektronischen Geräten in sogenannten Racks in Reihen angeordnet sind, als Kühlerwand ausgebildet, bildet folglich eine Kühlfläche, so dass sich eine größtmögliche Wärmetauscherfläche ergibt. Dies wiederum bedeutet, dass geringe Druckverluste auftreten und somit eine energetisch günstige Betriebsweise möglich ist. Es bedarf somit keines gesonderten Gehäuses für die Kühleinrichtung, so dass eine kostengünstige Konstruktion zur Verfügung steht.

Selbstverständlich wird die Erfindung auch dann nicht verlassen, wenn eine Wand nicht vollständig als Kühlfläche ausgebildet ist, z. B. ein vertikal und/oder horizontal verlaufender Bereich nicht die Funktion einer Kühlfläche ausübt.

Ferner ist vorgesehen, dass die Kühlerwand raumaußenseitig von einer Filterfläche vollflächig abgedeckt ist, so dass es nicht erforderlich ist, beim Austausch der Filterfläche den Raum zu betreten. Vielmehr werden die Tätigkeiten im Maschinenraum selbst durchgeführt, der gegenüber dem Raum, in dem die Racks angeordnet sind, durch die durch eine Wärmetauscherfläche gebildete Kühlerwand abgetrennt ist, und in dem gegebenenfalls die Ventilatoreinrichtung zum Absaugen der Warmluft und Zuführen dieser zur Wärmetauscherfläche sowie die üblichen weiteren zum Betreiben des Klimagerätes erforderlichen Bauteile wie Elektrogeräte und Steuerung vorhanden sind. Somit kann ein problemloser Austausch des Filters im Maschinenraum sowie eine Wartung der Funktionsbauteile des Klimageräts erfolgen.

Aufgrund der erfindungsgemäßen Lehre bildet der Raum, dem die gekühlte Luft zugeführt wird, dem Grunde nach den Kaltgang, so dass Hotspots vermieden werden. Die Warmgänge zwischen den in Reihen angeordneten Racks sind über Kanäle oder gleichwirkende Elemente mit der Ventilatoreinrichtung verbunden.

Es kann eine problemlose Luftmengenregelung in Abhängigkeit von der Temperatur in dem Warmgang erfolgen, da ein großes Raumvolumen für die gekühlte Abluft, also Zuluft zur Verfügung steht. Somit erfolgt quasi eine Selbstregelung, da Bereiche, die höhere Wärmelasten erzeugen, problemlos mit gekühlter Luft versorgt werden können. Es kann eine Leistungsregelung über eine lastabhängige Volumenstromregelung erfolgen, d. h. die Kühlleistung wird über den Volumenstrom geregelt. Dies ist bei Anordnungen, die übliche Kaltgänge zwischen den Reihen aufweisen, häufig nicht möglich. Erfindungsgemäß ist demgegenüber der Raum selbst der Kaltgang.

Die Kühlerwand kann des Weiteren modular aufgebaut sein, um eine problemlose Anpassung an die Wandfläche zu ermöglichen, die durch die Kühlerwand ersetzt wird.

Durch den modularen Aufbau (Wärmetauschermodule) kann eine optimale Abstimmung auf die erforderliche Leistung erfolgen und eine feine Skalierbarkeit ist möglich.

Um die Warmluft aus den Warmgängen abzuführen, ist insbesondere vorgesehen, dass der Raum eine abgehängte Decke aufweist, wobei der Deckenhohlraum mit dem bzw. den Warmgängen verbunden ist.

In Weiterbildung sieht die Erfindung vor, dass der Raum zumindest drei innere Wandungen aufweist, von denen zumindest eine, vorzugsweise jede als die Kühlerwand ausgebildet ist. Die Wandungen können z. B. ein U bilden.

Ein weiterer Lösungsvorschlag sieht vor, dass in zumindest einer Ecke des Raums eine geneigt zu den die Ecke bildenden Wandungen verlaufende Begrenzungswand vorgesehen ist, die als die Kühlerwand ausgebildet ist.

Die erfindungsgemäße Lehre kann auch dadurch verwirklicht werden, dass beabstandet zu einer Wandung des Raums eine Zwischenwandung angeordnet ist, die als die Kühlerwand ausgebildet ist.

Die Kühlerwand selbst ist bevorzugterweise als fluid- wie wasserdurchströmter Wärmetauscher ausgebildet.

Nach einem alternativen Vorschlag ist vorgesehen, dass der Raum einen Hohlboden aufweist, der über zumindest eine Öffnung mit dem Warmgang verbunden ist, und dass unterhalb der Öffnung eine Ventilatoreinrichtung angeordnet ist, über die die Abluft absaugbar und der Kühlerwand zuführbar ist.

Nach diesem Vorschlag ist die Ventilatoreinrichtung direkt unterhalb des Warmgangs in dem Doppelboden eingesetzt und saugt aus diesem die Abluft ab.

Es besteht die Möglichkeit, die Ventilatoreneinrichtungen in bestehende Doppelböden einzusetzen bzw. einzustecken.

Da jedem Warmgang eine entsprechende Ventilatoreinrichtung zugeordnet ist, ist eine individuelle Temperaturregelung möglich.

Die Saugöffnung der Ventilatoreinrichtung sollte dabei den Abmessungen üblicher einen Boden abdeckenden Bodenplatten wie 600 mm x 600 mm entsprechen.

Durch die diesbezügliche Möglichkeit ist es nicht erforderlich, dass ein gesondertes Warmgangwandsystem vorgesehen ist, über die die Warmluft im Deckenbereich des Raums abgesaugt wird. Vielmehr ist es nur erforderlich, dass der Warmgang deckenseitig verschlossen ist, d. h. grundsätzlich decken- und frontseitig.

Unabhängig hiervon können die einzelnen Ventilatoreneinrichtungen über eine Busverbindung - z. B. MODBus, BACnet, IP-Ethernet - vernetzt sein und z. B. mit einer zentralen Steuerung verbunden sein.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: eine erste Ausführungsform eines zu klimatisierenden Raums in Schnittdarstellung,
- Fig. 2: eine zweite Ausführungsform eines zu kühlenden Raums in Schnittdarstellung,
- Fig. 3: eine dritte Ausführungsform eines zu kühlenden Raums in Draufsicht,
- Fig. 4: eine vierte Ausführungsform eines zu kühlenden Raums in Draufsicht und
- Fig. 5: eine fünfte Ausführungsform eines zu kühlenden Raums in Draufsicht.

In den Figuren, in denen grundsätzlich für gleiche Elemente gleiche Bezugszeichen verwendet werden, sind verschiedene Ausgestaltungen von Räumen dargestellt, in denen wärmeabgebende elektronische Geräte gekühlt werden sollen. Hierbei handelt es sich insbesondere um Rechnerräume.

Die elektronischen Geräte sind dabei in sogenannten Racks angeordnet, die wiederum in Reihen zueinander ausgerichtet sind.

Kern der Erfindung ist es, dass eine der Begrenzungswandungen des Raums als Kühlerwand ausgebildet ist, wodurch eine größtmögliche Kühlerwand zur Verfügung steht. Die Kühlerwand ist als Wärmetauscherfläche gestaltet und wird von einem Fluid wie Wasser oder übliche Wassergemische zum Kühlen durchströmt.

Unabhängig hiervon ist erfindungsgemäß vorgesehen, dass die von den Warmgängen stammende Abluft unmittelbar einer Ventilatoreinrichtung zugeführt wird. Da dem

Raum gekühlte Zuluft zugeführt wird, ist der Raum folglich der Kaltgang. Hierdurch werden Hotspots vermieden.

Die Warmgänge werden über Kanäle oder Zwischenwandsysteme vorzugsweise mit einem Deckenhohlraum verbunden, über den die Warmluft der Ventilatoreinrichtung zugeführt wird.

Alternativ besteht die Möglichkeit, die Warmluft über einen Zwischenboden abzusaugen. In diesem Fall sollte jedem Warmgang ein gesonderter Ventilator, der im Zwischenboden angeordnet ist, zugeordnet werden, so dass eine individuelle Zonenregelung ermöglicht wird.

In den Prinzipdarstellungen der Figuren sind jeweils nur zwei Reihen von Racks dargestellt und somit ein einziger Warmgang. Selbstverständlich können in dem jeweiligen Raum eine Vielzahl von Reihen aufgestellt sein und somit mehrere Warmgänge bestehen.

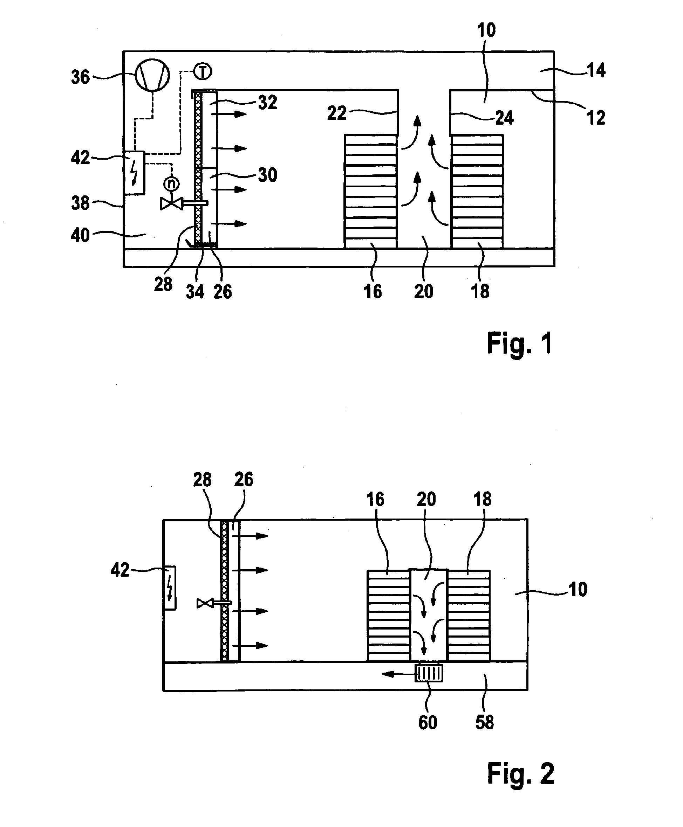

Der Fig. 1 ist rein prinzipiell ein Raum 10 zu entnehmen, der eine abgehängte Decke 12 zur Bildung eines Deckenhohlraums 14 aufweist. Innerhalb des Raums 10 sind im Ausführungsbeispiel mehrere, zeichnerisch jedoch nur zwei Reihen 16, 18 von zu kühlenden elektronischen Geräten wie Rechnern angeordnet. Die in sogenannten Racks angeordneten elektronischen Einheiten bilden folglich die Reihen 16, 18, die einen Warmgang 20 begrenzen. Der Warmgang 20 ist gegenüber dem Raum 10 über Zwischenwände oder sonstige Begrenzungen 22, 24 abgeschirmt und mit dem Deckenhohlraum 14 verbunden.

Erfindungsgemäß ist in der zeichnerischen Darstellung die linke Begrenzungswandung des Raums 10 als Kühlerwand 26 ausgebildet. Hierbei handelt es sich insbesondere um eine Wärmetauscherfläche, die von einem Kühlfluid wie Wasser durchströmt ist. Aus der zeichnerischen Darstellung ergibt sich des Weiteren, dass die Kühlerwand 26 modular aufgebaut sein kann. Im Ausführungsbeispiel besteht diese aus Einheiten 30, 32, die neben- und übereinander angeordnet sind.

Raumaußenseitig ist die Kühlerwand 26, also die Wärmetauscherfläche von einem Filter 28 abgedeckt, der sich flächenmäßig über die gesamte Kühlerwand 26 erstreckt, so dass Druckverluste minimiert werden.

Unterhalb der Kühlerwand 26 ist in gewohnter Weise eine Kondensatorwanne 34 angeordnet, um Kondensat zu sammeln.

Rein prinzipiell ergibt sich aus der Fig. 1 des Weiteren, dass die Abluft aus dem Warmgang 20 über eine Ventilatoreinrichtung 36 abgesaugt wird, über die sodann die Abluft der Kühlerwand 26 zugeführt wird. Die Kühlerwand 26 ist als Zwischenwand ausgebildet, so dass sich zwischen dieser und einer bauseitigen Wand 38 ein Zwischenraum 40 ergibt, der als Maschinenraum bezeichnet werden kann, in dem z. B. Elektrogeräte bzw. eine Steuerung 42 und sonstige zum Betrieb der Kühleinrichtung erforderlichen Elemente wie Ventil- oder Temperaturregler angeordnet sind, wie sich rein prinzipiell aus der Fig. 1 ergibt. Insoweit wird auf hinlänglich bekannte Bauelemente verwiesen.

Die aus dem Warmgang 20 stammende Abluft wird erwähntermaßen der Kühlerwand 26, also dem Wärmetauscher zugeführt, um sodann in den Raum 10 einzuströmen, der folglich als Kaltgang ausgebildet ist, von dem aus die in den Reihen 16, 18 angeordneten elektronischen Einrichtungen mit Kühlluft durchströmt werden.

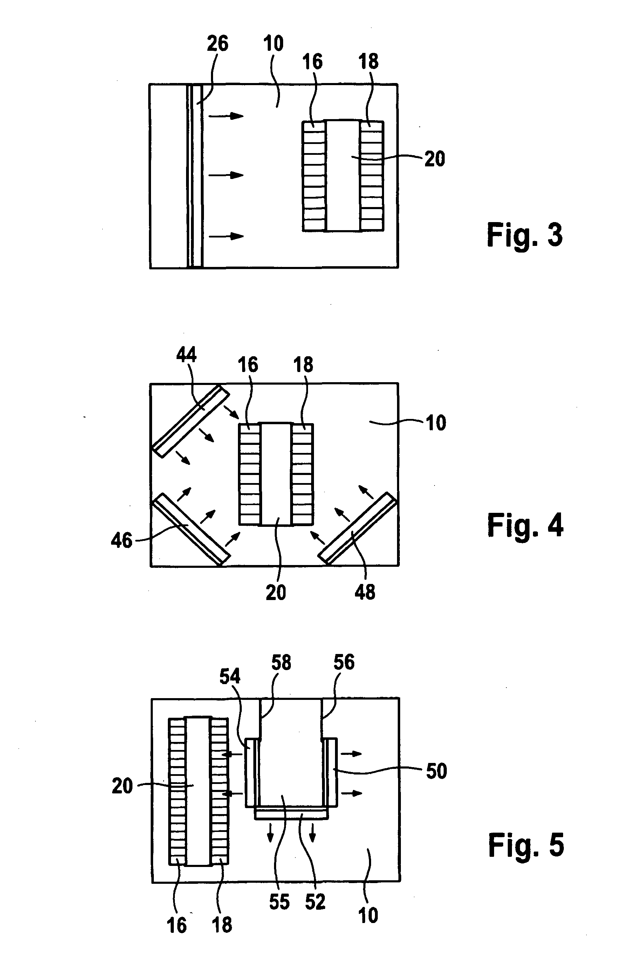

Die Ausbildung der Kühlerwände 26 bzw. deren Anordnung kann unterschiedlich erfolgen. So ist in Fig. 3 rein prinzipiell eine Anordnung als sogenannte Spange vorgesehen. Die Kühlwand 26 erstreckt sich dabei über die gesamte Breite des Raums 10. In dem Raum 10 sind rein beispielhaft zwei Reihen von zu kühlenden elektronischen Geräten dargestellt, zwischen denen der Warmgang 20 verläuft, der gegenüber dem Raum 10 insoweit verschlossen ist, dass die Reihen von außen von der gekühlten Abluft (Zuluft) durchströmt werden.

In Fig. 4 sind in dem Raum 10 in drei Ecken jeweils eine Kühlerwand 44, 46, 48 angeordnet, die sich über die gesamte Höhe des Raums 10 bis zur ggf. vorhandenen Zwischendecke erstrecken. Innerhalb des Raums 10 sind gleichfalls rein beispielhaft zwei Reihen 16, 18 von zu kühlenden elektronischen Geräten dargestellt, zwischen denen der gegenüber dem Raum 20 abgeschirmte Warmgang 20 verläuft.

Fig. 5 zeigt eine zentrale Anordnung von im Ausführungsbeispiel drei Kühlerwänden 50, 52, 54, die ein U bilden. Der von den Kühlerwänden 50, 52, 54 gebildete Innenraum 55 ist gegenüber dem Raum 10 über Trennwände 56, 58 abgetrennt. Es wird gleichfalls erkennbar, dass die gekühlte Abluft, die aus den Kühlwänden 50, 52, 54 austritt, die in den Reihen 16, 18 angeordneten elektronischen Geräte durchsetzt, um sodann aus dem zwischen den Reihen 16, 18 verlaufenden Warmgang 20 die Abluft über einen nicht dargestellten Ventilator abzusaugen und in den zwischen den Kühlwänden 50, 52 54 vorhandenen Innenraum 55 zu fördern.

Bei den diesbezüglichen Anordnungen kann eine Luftmengenregulierung in Abhängigkeit von der Rücklufttemperatur erfolgen, sofern die Temperatur der Zuluft konstant ist. Unabhängig hiervon kann mit überaus geringen Luftmengen gearbeitet werden im Vergleich zu Anordnungen, bei denen die Zuluft Doppelböden durchströmt, da im vorliegenden Fall kein Doppelbodenvordruck nötig ist.

Fig. 2 zeigt eine weitere bevorzugte Variante der erfindungsgemäßen Lehre. So ist entsprechend den Ausführungsbeispielen der Fig. 1 und 3 - 5 eine Wand über die gesamte Höhe des Raums 10 als Kühlerwand ausgebildet. Diese Wand ist entsprechend der Fig. 1 mit dem Bezugszeichen 26 versehen. Raumabgewandt ist die Kühlerwand 26, d. h. deren Kühlfläche mit dem Filter 28 abgedeckt.

Abweichend von den Ausführungsbeispielen der Fig. 1 weist der Raum 10 keinen Deckenhohlraum auf, über den die Abluft abgesaugt wird. Vielmehr weist der Raum 10 einen Hohlboden 58 auf, in dem unterhalb des Warmgangs 20 zumindest eine Öffnung vorgesehen ist, in der unmittelbar eine Ventilatoreinrichtung 60 angeordnet ist, bei der es sich um einen gehäusefreien Radialventilator handeln kann. Die Abluft wird somit aus jedem Warmgang 20 über eine gesonderte Ventilatoreinrichtung abgesaugt, so dass eine Luftmengenregulierung in Abhängigkeit von der Temperatur in dem Warmgang 20 erfolgt. Da in dem Raum 10 mehr als zwei Reihen von Racks und somit mehrere Warmgänge vorgesehen sind, ist folglich jeder Warmgang individuell regelbar. Selbstverständlich wird die Erfindung dann nicht verlassen, wenn sämtlichen Warmgängen eine oder mehrere zentrale Ventilatoreinrichtungen zugeordnet sind.

## Patentansprüche

1. Klimatisierter Raum (10) mit diesen begrenzenden Wandungen, einer Kühleinrichtung sowie in dein Raum in Reihen (16, 18) angeordneten zu kühlenden elektronischen Geräten, wobei jede Reihe auf einer Seite einen Warmgang (20) begrenzt, der zwischen zwei Reihen verläuft,
**dadurch gekennzeichnet,**
**dass** zumindest eine den Raum (10) begrenzende Wandung als Kühlerwand (26) ausgebildet ist, über die dem Raum gekühlte Abluft zuführbar ist, die aus dem Warmgang (20) abgesaugt ist, der gegenüber dem Raum strömungstechnisch getrennt ist.

2. Raum nach Anspruch 1,
**dadurch gekennzeichnet,**
**dass** die Kühlerwand (26) raumaußenseitig von einer Filterfläche (28) vorzugsweise vollflächig abgedeckt ist.

3. Raum nach Anspruch 1 oder 2,
**dadurch gekennzeichnet,**
**dass** der Raum (10) eine einen Hohlraum (14) begrenzende abgehängte Decke (12) aufweist, wobei der Deckenhohlraum mit dem Warmgang (20) verbunden ist.

4. Raum nach zumindest einem der vorhergehenden Ansprüche,
**dadurch gekennzeichnet,**
**dass** die Kühlerwand (26) ein fluid- wie wasserdurchströmter Wärmetauscher ist.

5. Raum nach zumindest einem der vorhergehenden Ansprüche,
**dadurch gekennzeichnet,**
**dass** der Raum (10) einen Hohlboden (58) aufweist, der über zumindest eine Öffnung mit dem Warmgang (20) verbunden ist, und dass unterhalb der Öffnung eine Ventilatoreinrichtung (60) angeordnet ist, über die die Abluft absaugbar und der Kühlerwand (26) zuführbar ist.

6. Raum nach zumindest einem der vorhergehenden Ansprüche,
**dadurch gekennzeichnet,**
**dass** die aus dem Warmgang (20) abgesaugte Menge der Abluft in Abhängigkeit von deren Temperatur regelbar ist.

7. Raum nach zumindest einem der vorhergehenden Ansprüche,
**dadurch gekennzeichnet,**
**dass** der Raum (10) zumindest drei innere Begrenzungswandungen (50, 52, 54) aufweist, von denen zumindest eine, vorzugsweise jede als die Kühlerwand ausgebildet ist.

8. Raum nach zumindest einem der vorhergehenden Ansprüche,
**dadurch gekennzeichnet,**
**dass** in zumindest einer Ecke des Raums eine geneigt zu den die Ecken bildenden Wandungen eine Begrenzungswandung des Raums angeordnet ist, die als die Kühlerwand (44, 46, 48) ausgebildet ist.

9. Raum nach zumindest einem der vorhergehenden Ansprüche,
**dadurch gekennzeichnet,**
**dass** beabstandet zu einer bauseitigen Wandung des Raums (10) eine diesen begrenzende Zwischenwandung angeordnet ist, die als die Kühlerwand (26) ausgebildet ist.

10. Raum nach zumindest einem der vorhergehenden Ansprüche,
**dadurch gekennzeichnet,**
**dass** die die Kühlerwand (30) bildende Wandung einen Arbeitsraum (40) begrenzt, in dem ein Elektroteil bzw. eine Steuerung der Kühleinrichtung angeordnet ist.

11. Raum nach zumindest einem der vorhergehenden Ansprüche,
**dadurch gekennzeichnet,**
**dass** in dem Arbeitsraum (40) eine die Abluft absaugende Ventilatoreinrichtung (36) angeordnet ist.

12. Raum nach zumindest einem der vorhergehenden Ansprüche,
**dadurch gekennzeichnet,**
**dass** in dem Raum (10) zumindest vier Reihen von zu kühlenden elektronischen Einrichtungen angeordnet sind.

13. Raum nach zumindest einem der vorhergehenden Ansprüche,
**dadurch gekennzeichnet,**
**dass** die Wärmetauscher gehäuselos angeordnet sind.

## Claims

1. Air-conditioned room (10) having walls limiting it, a cooling device and electronic units to be cooled arranged in said room in rows (16, 18), where each row limits on one side a hot aisle (20) passing between two rows,
**wherein**
at least one wall cooling said room (10) is designed as a cooler wall (26) via which cooled exhaust air can be supplied to said room and is extracted from the hot aisle (20) which is separated from the room in terms of fluid mechanics.

2. Room according to claim 1,
**wherein**
the cooler wall (26) is covered on the outside of said room by a filter surface (28) preferably over its full area.

3. Room according to claim 1 or 2,
**wherein**
said room (10) has a suspended ceiling (12) limiting a cavity (14), said ceiling cavity being connected to the hot aisle (20).

4. Room according to at least one of the preceding claims,
**wherein**
the cooler wall (26) is a heat exchanger with fluid such as water flowing through.

5. Room according to at least one of the preceding claims,
**wherein**
said room (10) has a hollow floor (58) connected via at least one opening to the hot aisle (20), and wherein below said opening a fan device (60) is arranged via which the exhaust air can be extracted and supplied to the cooler wall (26).

6. Room according to at least one of the preceding claims,
**wherein**
the quantity of exhaust air extracted from the hot aisle (20) can be regulated depending on its temperature.

7. Room according to at least one of the preceding claims,
**wherein**
said room (10) has at least three inner limiting walls (50, 52, 54) of which at least one and preferably every one is designed as the cooler wall.

8. Room according to at least one of the preceding claims,
**wherein**
in at least one corner of said room a limiting wall of said room is arranged at an angle to the walls forming the corners and is designed as the cooler wall (44, 46, 48).

9. Room according to at least one of the preceding claims,
**wherein**
an intermediate wall limiting said room (10) is arranged at a distance to an existing building wall of said room and is designed as the cooler wall (26).

10. Room according to at least one of the preceding claims,
**wherein**
the wall forming the cooler wall (30) limits a work room (40) in which an electric component and/or a control for the cooling device is arranged.

11. Room according to at least one of the preceding claims,
**wherein**
a fan device (36) extracting the exhaust air is arranged inside the work room (40).

12. Room according to at least one of the preceding claims,
**wherein**
at least four rows of electronic devices to be cooled are arranged inside said room (10).

13. Room according to at least one of the preceding claims,
**wherein**
the heat exchangers are arranged without casings.

## Revendications

1. Local climatisé (10) avec cloisons le délimitant, avec un dispositif réfrigérant ainsi que des appareils électroniques destinés à être refroidis et disposés en rangées (16, 18) dans ledit local, sachant que chaque rangée délimite d'un côté une allée chaude (20) qui s'étend entre deux rangées,
**caractérisé en ce**
**qu'**au moins une cloison délimitant le local (10) est conçue en tant que paroi réfrigérante (26) par l'intermédiaire de laquelle peut être introduit dans le local de l'air évacué refroidi qui est aspiré hors de l'allée chaude (20), qui est elle-même séparée du local par des mesures relevant de la mécanique des fluides.

2. Local selon la revendication 1,
**caractérisé en ce**
**que** du côté extérieur du local, la paroi réfrigérante (26) est recouverte, de préférence sur toute sa surface, par une surface filtrante (28).

3. Local selon la revendication 1 ou 2,
**caractérisé en ce**
**que** le local (10) présente un plafond suspendu (12) délimitant une cavité (14), ladite cavité du plafond étant reliée à l'allée chaude (20).

4. Local selon au moins une des revendications précédentes,
**caractérisé en ce**
**que** la paroi réfrigérante (26) est un échangeur de chaleur traversé par un fluide tel que de l'eau.

5. Local selon au moins une des revendications précédentes,
**caractérisé en ce**
**que** le local (10) présente un plancher creux (58) qui est relié par au moins une ouverture à l'allée chaude (20), et que sous l'ouverture est disposé un dispositif de ventilation (60) par l'intermédiaire duquel l'air évacué peut être aspiré et acheminé vers la paroi réfrigérante (26).

6. Local selon au moins une des revendications précédentes,
**caractérisé en ce**
**que** la quantité d'air évacué aspiré hors de l'allée chaude (20) est réglable en fonction de sa température.

7. Local selon au moins une des revendications précédentes,
**caractérisé en ce**
**que** le local (10) présente au moins trois parois de séparation (50, 52, 54) intérieures, dont au moins une, de préférence chacune, est conçue en tant que paroi réfrigérante.

8. Local selon au moins une des revendications précédentes,
**caractérisé en ce**
**que** dans au moins un angle du local est disposée une paroi de séparation du local en biais par rapport aux cloisons formant l'angle et conçue en tant que paroi réfrigérante (44, 46, 48).

9. Local selon au moins une des revendications précédentes,
**caractérisé en ce**
**qu'**à distance d'une cloison du bâtiment du local (10) est disposée une paroi intermédiaire qui délimite ledit local et est conçue en tant que paroi réfrigérante (26).

10. Local selon au moins une des revendications précédentes,
**caractérisé en ce**
**que** la cloison formant la paroi réfrigérante (30) délimite un espace de travail (40) dans lequel est disposé un élément électrique et/ou une commande du dispositif réfrigérant.

11. Local selon au moins une des revendications précédentes,
**caractérisé en ce**
**qu'**un dispositif de ventilation (36) aspirant l'air évacuée est disposé dans l'espace de travail (40).

12. Local selon au moins une des revendications précédentes,
**caractérisé en ce**
**qu'**au moins quatre rangées d'appareils électroniques à refroidir sont disposées dans le local (10).

13. Local selon au moins une des revendications précédentes,
**caractérisé en ce**
**que** les échangeurs de chaleur sont disposés sans boîtier.
